# EUROPÄISCHE PATENTSCHRIFT

(11) **EP 0 354 266 B1**
(45) Veröffentlichungstag und Bekanntmachung des Hinweises auf die Patenterteilung: **20.10.1993**
(21) Anmeldenummer: 88113109.8
(22) Anmeldetag: 12.08.1988
(51) Int. Cl.: C23F 1/08, H05K 3/06

(54) **Verfahren und Vorrichtung zum Ätzen eines zumindest Teilweise aus Metall bestehenden Ätzguts**
Etching process and apparatus for work pieces composed at least partly of metals
Procédé et appareil pour le décapage de pièces composées au moins partiellement de métal

(43) Veröffentlichungstag der Anmeldung: 14.02.1990
(73) Patentinhaber: International Business Machines Corporation, Armonk, N.Y. 10504 (US)
(72) Erfinder: Scheithauer, Alfred, D-7000 Stuttgart 1 (DE); Alberth, Wolfgang, D-7312 Kirchheim/Teck (DE); Pohl, Gert, D-7032 Sindelfingen (DE); Ziegler, Herbert, D-7030 Böblingen 4 (DE)
(74) Vertreter: Schäfer, Wolfgang, Dipl.-Ing.

(56) Entgegenhaltungen:
- EP-A- 0 222 348
- WO-A-85/02630
- FR-A- 2 482 405
- PATENT ABSTRACTS OF JAPAN, Band 9, Nr. 205 (C-244)[1642], 19. September 1984; & JP-A-59 093 881

## Beschreibung

Die Erfindung betrifft ein Verfahren zum Ätzen eines zumindest teilweise aus Metall bestehenden Ätzguts, vorzugsweise von gedruckten Leiterplatten, mit einer Ätzmaschine, welche Düsenstöcke mit einer Vielzahl von Düsen umfaßt, die oberhalb und unterhalb des Ätzguts senkrecht zueinander angeordnet sind und denen Ätzmittel über Flüssigkeits-Sammelleitungen und über von diesen abzweigende individuelle Flüssigkeits-Zufuhrleitungen zugeführt wird.

Verfahren und Vorrichtungen zum Ätzen von teilweise aus Kupfer bestehendem Ätzgut, vorzugsweise von Leiterplatten, sind aus den deutschen Offenlegungsschriften DE-A-35 39 886 und DE-A-35 39 874 bekannt. Aus DE-A-35 39 874 (≡EPA 0 222 348) ist eine Vorrichtung bekannt, bei der eine Einrichtung, bestehend aus einer optischen Reflexions- und einer Dicken-Meßeinrichtung, Auskunft über die Menge des am jeweiligen Ätzgut abzuätzenden Metalls gibt und ein Detektor anzeigt, wenn das zu bearbeitende Ätzgut in die Ätzmaschine einläuft.

Die korrespondierenden elektrischen Signale werden in einer zentralen Steuereinheit zu einem Signal verarbeitet, das einer Dosiereinrichtung zugeführt wird, die eine diesem Signal entsprechende Menge Oxidationsmittel und/oder Säure dem entsprechenden Vorratstank entnimmt und dem von der Pumpe zu den Düsen geförderten Ätzmittel zugibt.

Aus den deutschen Offenlegungsschriften DE-A-33 45 206 und DE-A-33 45 125 (≡ WO 85/02630) sind Vorrichtungen zur Behandlung von Gegenständen mittels einer Flüssigkeit, insbesondere Ätz- oder Entwicklermaschinen zur Leiterplattenherstellung bekannt, bei denen die Menge der Behandlungsflüssigkeit, welche zu den verschiedenen in einem Düsenstock angeordneten Düsen fließt, für jede Düse individuell gemessen und eingestellt werden kann. Hierzu ist jeder Düse eine individuelle Flüssigkeits-Zufuhrleitung zugeordnet, in welcher ein Durchflußmengenmesser in Reihe mit einem Regelventil eingesetzt ist.

Die in den zuvor genannten Offenlegungschriften beschriebenen Vorrichtungen sind zwar gegenüber dem Stand der Technik dahingehend verbessert, daß die Düsen nicht mehr direkt an der Flüssigkeits-Sammelleitung angeordnet sind, was eine Kontrolle und Einstellung der den einzelnen Düsen zugeführten Flüssigkeitsmengen unmöglich macht, sondern daß jeder Düse eine individuelle Flüssigkeits-Zufuhrleitung zugeordnet ist, welche zur Flüssigkeits-Sammelleitung führt, und daß in jeder individuellen Zufuhrleitung ein Durchflußmengenmesser und ein Regelventil vorgesehen sind. Auf diese Weise ist es möglich, die individuell zu jeder Düse strömende Flüssigkeitsmenge optisch oder auch elektrisch zu kontrollieren, um Veränderungen im Ätzmittelstrom festzustellen. Die aus jeder einzelnen Düse austretende Ätzmittelmenge bzw. der Sprühdruck kann dann individuell geregelt werden, wodurch ein an das spezielle Ätzgut angepaßtes Sprühbild erhalten werden soll. In beiden Offenlegungsschriften fehlen aber sämtliche Einzelheiten, wie die beschriebene Regelung bzw. Steuerung des Sprühdrucks in der Praxis tatsächlich erfolgen soll, insbesondere dann, wenn der Verlauf der Leiterzüge auf der Oberseite der Leiterplatten ein anderer ist als auf der Unterseite derselben, oder verallgemeinert, wenn die zu ätzenden Strukturen auf der Oberseite des Ätzguts sich von denen auf der Unterseite unterscheiden.

JP-A 59 093881 ≡ Patent Abstr. 9 205 vom 19. 9. 1984 beschreibt eine Ätzvorrichtung für Leiterplattensubstrate, bei der die Düsen von Düsenstöcken auf der Oberseite des Substrats in einer bestimmten Richtung linear vor- und zurückbewegt werden. Die Düsen von Düsenstöcken auf der Unterseite des Substrats führen dieselbe Bewegung aus, aber in einer Richtung von ± 15° zur Senkrechten der Bewegungsrichtung der Düsenstöcke auf der Oberseite während des Durchlaufs des Substrats zwischen oberen und unteren Düsenstöcken. Mit welchem Sprühdruck des Ätzmittels die Düsenstöcke bzw. Düsen zu beaufschlagen sind und wie der Verlauf der zu ätzenden Leiterzugstrukturen auf Ober- und Unterseite relativ zur Durchlaufrichtung der Substrate sein muß, ist dem japanischen Patentabstrakt nicht zu entnehmen.

Aufgabe der vorliegenden Erfindung ist es, ein Verfahren der eingangs genannten Art anzugeben, mit dem das Ätzgut beidseitig, unabhängig von der Dichte, Höhe und dem Verlauf der auf beiden Seiten zu ätzenden Strukturen, gleichmäßig geätzt werden kann. Das Verfahren soll insbesondere anwendbar sein zum Ätzen von Leiterplatten, bei denen die Leiterzüge auf der Oberseite der Leiterplatten in anderer Richtung verlaufen als auf der Unterseite, beispielsweise senkrecht zueinander.

Die Aufgabe der Erfindung wird gelöst durch ein Verfahren der eingangs genannten Art, das dadurch gekennzeichnet ist, daß die Sprühdrucke in jedem Düsenstock oder in den einzelnen Düsen, bei Anordnung der Leiterzüge parallel zu den Düsenstöcken und zur Durchlaufrichtung durch die Ätzmaschine, auf der Leiterzugdichte entsprechende, aber während des Durchlaufs der Leiterplatte konstante Werte eingestellt werden; bei Anordnung der Leiterzüge parallel zu den Düsenstöcken aber senkrecht zur Durchlaufrichtung durch die Ätzmaschine, auf der Leiterzugdichte entsprechende Anfangswerte eingestellt werden, die beim Durchlauf der Leiterplatte an jedem Düsenstock, bzw. an jeder Düse in Abhängigkeit von der Leiterzugdichte angehoben oder abgesenkt werden; und Meß- und Regeleinrichtungen vorgesehen sind, mit denen die den Düsenstöcken oder den einzelnen Düsen zugeführten Flüssigkeitsmengen bzw. die Sprühdrucke an denselben individuell regelbar sind.

Auf diese Weise kann eine von der Dichte und Höhe und dem Verlauf der zu ätzenden Strukturen unabhängige konstante Ätzrate auf Ober- und Unterseite des Ätzguts erhalten werden.

Es wird auch eine Vorrichtung beschrieben, bei der die Düsenstöcke oberhalb und unterhalb des Ätzguts senkrecht zueinander angeordnet sind und Meß- und Regeleinrichtungen vorgesehen sind, mit denen die zugeführten Flüssigkeitsmengen bzw. die Sprühdrucke für die Düsenstöcke oder für die einzelnen Düsen individuell regelbar sind.

Die Erfindung wird nachfolgend und anhand der Figuren 1A, 1B, 2 und 3 näher beschrieben. Im einzelnen stellen dar:
- Fig. 1A: Eine Leiterplatte, die in Richtung des Leiterzugmusters in die Ätzmaschine eingeführt wird (Stand der Technik);
- Fig. 1B: Eine Leiterplatte, die senkrecht zur Richtung des Leiterzugmusters in die Ätzmaschine eingeführt wird;
- Fig. 2: Eine Vorrichtung zur Durchführung des erfindungsgemäßen Verfahrens mit einer Anordnung zur Überwachung und Steuerung desselben:
- Fig. 3: Den Regelkreis der Vorrichtung gemäß Fig. 2.

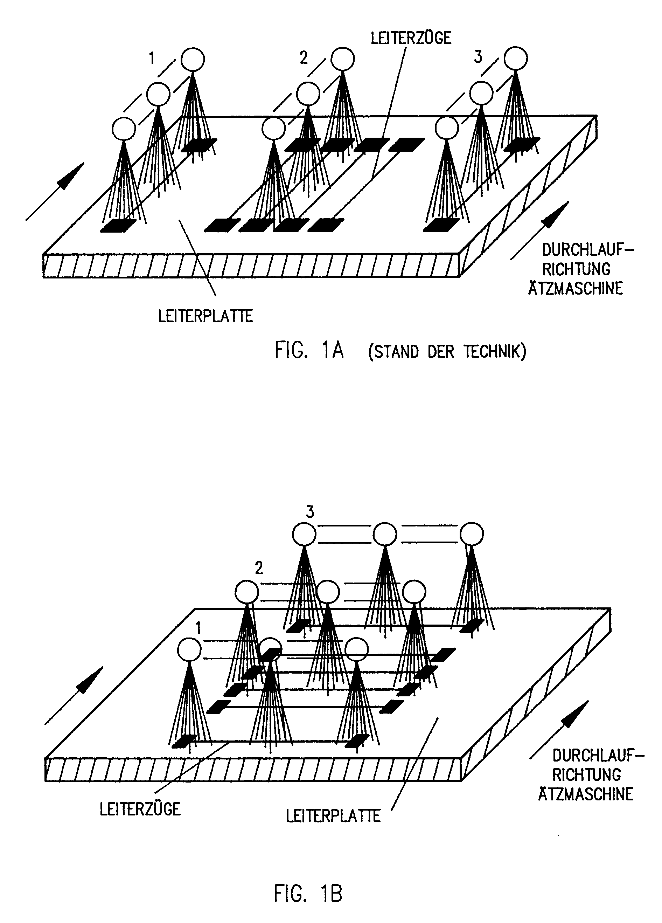

In Fig 1A ist eine Leiterplatte, welche nach dem Subtraktiv-Ätzverfahren bearbeitet wird, dagestellt. Bei diesem Verfahren wird das gewünschte Leiterzugbild mit einem alkali- oder lösungsmittellöslichen Resist auf das kupferkaschierte Laminat aufgebracht, wobei die in Fig. 1A abgebildeten Leiterzüge mit Resist bedeckt sind (nicht dargestellt), und das nicht mit Resist bedeckte Kupfer auf der Oberfläche der Leiterplatte beim Durchlauf durch die Ätzmaschine abgeätzt wird. Auf Leiterplatten befinden sich in der Regel neben Bereichen mit dichten Leiterzugmustern auch einzelne Leiterzüge. Es ist bekannt, daß die einzelne Leiterzüge abdeckenden Resistmuster wegen des fehlenden Flankenschutzes seitlich stärker unterätzt werden als diejenigen Resistmuster, welche Leiterzüge eines dichten Leiterzugmusters abdecken, mit der Folge, daß die einzelnen Leiterzüge auf der Aussenseite von Fig. 1A nach dem Ätzen eine geringere Leiterzugbreite aufweisen als die in der Mitte der Leiterplatte abgebildeten Leiterzüge des dichten Leiterzugmusters.

Um beim Ätzen, unabhängig von der Lage der Leiterzüge, im wesentlichen einheitliche Leiterzugbreiten zu erhalten, wurde vorgeschlagen, den Sprühdruck an den Düsen für einen bestimmten Produktbereich entsprechend zu reduzieren. So wird beispielsweise bei Reduktion des Sprühdrucks in den beiden außen liegenden Düsenstöcken 1 und 3 von Fig. 1A um etwa 30 % eine im wesentlichen einheitliche Leiterzugbreite der einzelnen Loiterzüge und des dichten Leiterzugmusters auf der Leiterplatte erhalten. Die Einstellung des Sprühdrucks auf bestimmte Werte für bestimmte Produktbereiche setzt allerdings voraus, daß die Leiterzugmuster parallel zu den Düsenstöcken mit den darin enthaltenen Düsen angeordnet sind und die Leiterplatten in Richtung der Leiterzüge durch die Ätzmaschine geführt werden. Die Einstellung des Sprühdrucks an den einzelnen Düsenstöcken ist stationär. Ein Vorteil dieses Verfahrens ist, daß, bei entsprechender Anordnung der Leiterzüge, auf eine aufwendige Prozeßsteuerung verzichtet werden kann.

Im Zuge des technischen Fortschritts sind jedoch bei den heute zu prozessierenden Leiterplatten die Leiterzüge auf der Ober- und auf der Unterseite der Leiterplatten senkrecht zueinander angeordnet. Das bedeutet, daß nur auf der Plattenseite, auf der die Leiterzüge parallel zu den Düsenstöcken angeordnet sind und wenn die Leiterplatten in dieser Richtung durch die Ätzmaschine geführt werden, durch entsprechende Einstellung des Sprühdrucks ein verbessertes Ätzverhalten erzielt werden kann. Auf der anderen Plattenseite ist, wegen der Anordnung der Leiterzüge senkrecht zur Durchlaufrichtung durch die Ätzmaschine (Fig. 1B), ein verbessertes Ätzverhalten durch eine stationäre Einstellung des Sprühdrucks an den einzelnen Düsenstöcken oder Düsen nicht erzielbar.

Ein verbessertes Ätzverhalten bei einer Anordnung der Leiterzüge senkrecht zur Durchlaufrichtung kann erzielt werden, wenn der Sprühdruck der einzelnen Düsenstöcke, bzw. der einzelnen Düsen während des Durchlaufs der Leiterplatte durch die Ätzmaschine in Abhängigkeit von der Leiterzugdichte kontinuierlich geregelt wird. Wenn beispielsweise gemäß Fig. 1B eine Leiterplatte in die Ätzmaschine senkrecht zur Richtung des Leiterzugmusters eingeführt wird, dann wird der Sprühdruck von Düsenstock 1, bzw. der einzelnen Düsen desselben, wenn sich unter diesen ein einzelner Leiterzug befindet, durch die Steuerelektronik abgesenkt. Wenn das Teil weitertransportiert wird, wird der Sprühdruck von Düsenstock 1, unter dem sich jetzt ein dichtes Leiterzugmuster befindet, der Leiterzugdichte entsprechend angehoben, während der Sprühdruck von Düsenstock 2, unter dem sich jetzt ein einzelner Leiterzug befindet, durch die Steuerelektronik abgesenkt wird, usw.

Mit dem erfindungsgemäßen Verfahren und der Vorrichtung zur Durchführung desselben eröffnen sich eine Vielzahl von Möglichkeiten zur Bearbeitung von Ätzgut. So können beispielsweise die Sprühdrucke an den Düsenstöcken auf der Ober- und Unterseite während des Durchlaufs des Ätzguts auf konstante Werte eingestellt und/oder variabel geregelt werden. Ein besonders vorteilhaftes Ätzverhalten wird erzielt, wenn statt einer Ätzkammer zwei hintereinander geschaltete Ätzkammern verwendet werden und in der ersten Ätzkammer die Sprühdrucke an den Düsenstöcken auf der Oberseite auf konstante Werte eingestellt und an den Düsenstöcken auf der Unterseite, welche senkrecht zu denen auf der Oberseite angeordnet sind, in Abhängigkeit von den zu ätzenden Strukturen des durchlaufenden Ätzguts kontinuierlich geregelt werden. In der zweiten Ätzkammer sind die Düsenstöcke auf der Ober- und der Unterseite des Ätzguts senkrecht zu denen in der ersten Ätzkammer angeordnet, und die Sprühdrucke an den Düsenstöcken werden auf der Oberseite kontinuierlich geregelt und an den Düsenstöcken auf der Unterseite auf konstante Werte eingestellt. Durch diese Art der Regelung, die anhand eines Ausführungsbeispiels später noch näher erläutert wird, kann an den einzelnen Punkten des Ätzguts ein wesentlich verbessertes Ätzverhalten erzielt werden. Eine individuelle Regelung kann an den einzelnen Düsenstöcken erfolgen. Da allen Düsen individuelle Flüssigkeits-Zufuhrleitungen mit einem Flüssigkeits-Durchflußmengenmesser und einem Regelventil zugeordnet sind, können die Sprühdrucke nicht nur an den Düsenstöcken sondern auch an den einzelnen Düsen eines jeden Düsenstocks durch die Steuerelektronik unterschiedlich geregelt werden, was eine weitere Verfeinerung des Ätzverhaltens ermöglicht.

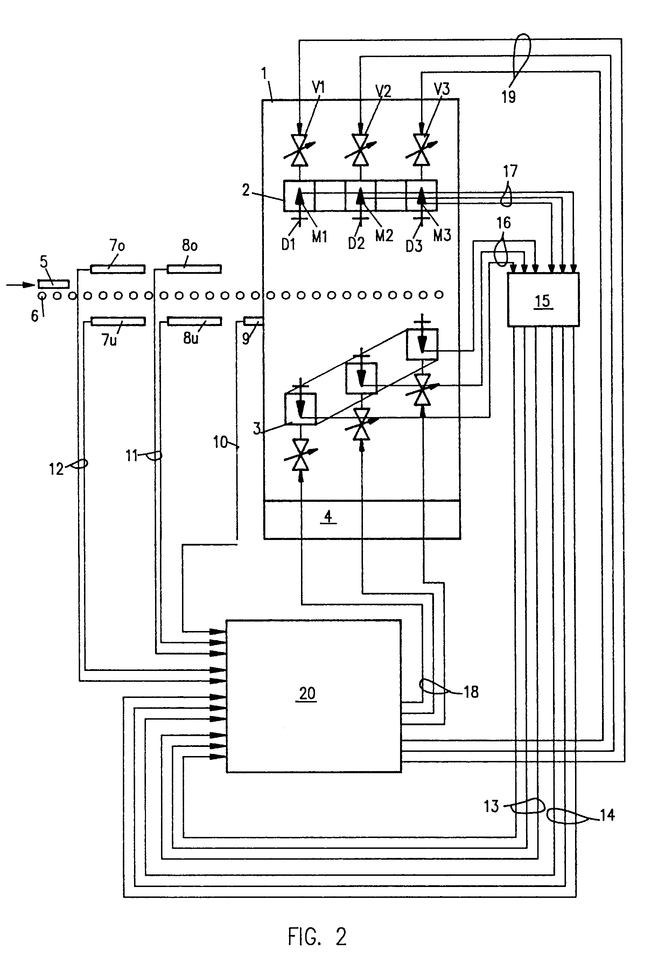

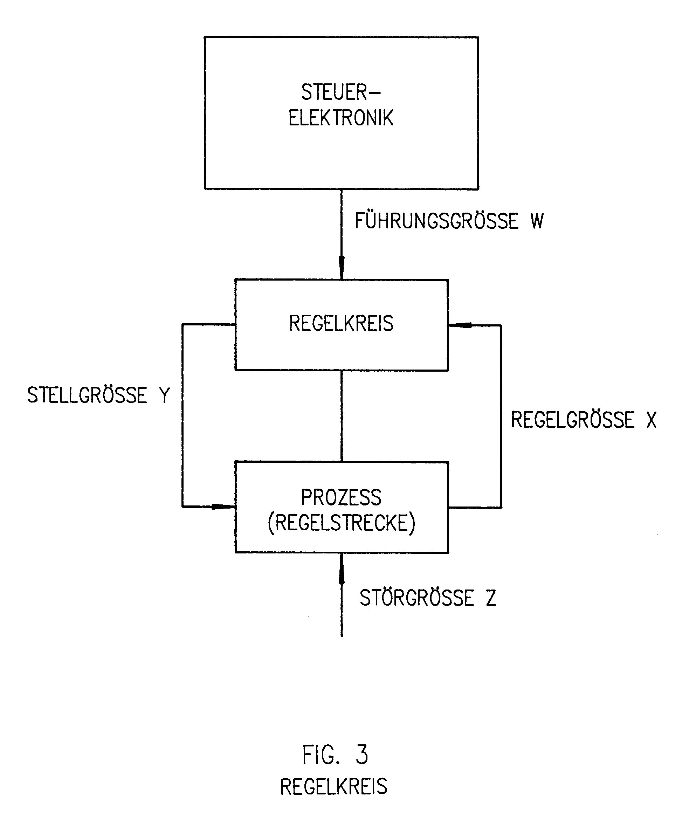

Nachfolgend wird eine Vorrichtung zur Durchführung des erfindungsgemäßen Verfahrens anhand der Fign. 2 und 3 beschrieben. Bei der erfindungsgemäßen Vorrichtung werden in der Regel alle der Anpassung des Sprühdrucks an die abzutragende Metallmenge dienenden Einstellungen weitestgehend automatisch vorgenommen, so daß keine Fehler durch das Bedienungspersonal auftreten können. Es kann jedoch auch über ein Tastenfeld ein Code für das jeweils zu bearbeitende Ätzgut bzw. die abzuätzende Metallmenge direkt von Hand in die zentrale Steuerelektronik eingegeben werden. Diese Ausgestaltung ist besonders dann von Vorteil, wenn große Serien gleichbleibender Teile, beispielsweise Leiterplatten, bearbeitet werden. In jedem Fall muß die Geschwindigkeit, mit der das jeweils zu bearbeitende Ätzgut durch die Ätzanlage geführt werden soll, von Hand in die zentrale Steuerelektronik eingegeben werden.

In der in Fig. 2 dargestellten Ätzanlage sind in den Düsenstöcken 2 und 3 der Ätzkammer 1 nur jeweils 3 Düsen D1 bis D3 dargestellt, deren Sprühöffnungen nach unten bzw. nach oben gerichtet sind. Selbstverständlich trägt jeder Düsenstock, je nach den Abmessungen der zu ätzenden Teile, weit mehr Düsen in regelmäßiger Anordnung, auf deren Darstellung zur Entlastung der Zeichnung verzichtet wurde. Entsprechendes gilt für die Durchflußmengenmesser M1 bis M3 und die Regelventile V1 bis V3. Des weiteren wurde, der besseren Übersichtlichkeit halber, auf die zeichnerische Darstellung der Pumpen, Leitungen und Vorratsbehälter für Ätzmittel, Säure und Oxidationsmittel verzichtet. Einzelheiten hierzu sind im Stand der Technik beschrieben. In Fig. 2 ist im wesentlichen die Regelung bzw. Steuerung des Sprühdrucks des Ätzmittels an den Düsen in Abhängigkeit von der vom Ätzgut abzutragenden Metallmenge dargestellt.

Die dargestellte Ätzanlage umfaßt einen Eingangsteil, in dem das Ätzgut 5, beispielsweise Leiterplatten, auf eine Rollenbahn 6 gelegt wird. Die Rollenbahn 6 befördert das Ätzgut von links nach rechts durch die Ätzanlage. Zur Bestimmung der Menge des Metalls, die bei dem zu bearbeitenden Ätzgut 5 abgetragen werden muß, sind die Einrichtungen 7 o, u und 8 o, u vorgesehen. Die Einrichtung 7 o, u ist eine an sich bekannte, optische Reflexions-Meßeinrichtung, mit der aus der Reflexion von Licht die auf der Ober- und Unterseite des Ätzguts 5 freiliegende Metallfläche ermittelt wird. Die Einrichtung 8 o, u ist eine ebenfalls bekannte Dickenmeßeinrichtung, mit der die Dicke der abzutragenden Metallschicht auf der Ober- und Unterseite des Ätzguts 5 ermittelt wird. Der Eintritt des Ätzguts 5 in die Ätzkammer 1 wird durch einen Detektor 9 überwacht. Bei dem Detektor 9 kann es sich um eine Reflexions-Lichtschranke oder einen Mikroschalter handeln.

In der Ätzkammer 1 sind ein oberer, eine Vielzahl von Düsen D1 bis D3 aufweisender Düsenstock 2 und ein unterer, ebenfalls eine Vielzahl von Düsen aufweisender Düsenstock 3 angeordnet. Die Düsenstöcke 2 und 3 sind senkrecht zueinander angeordnet. Das auf der Rollenbahn 6 fortbewegte Ätzgut wird von oben und unten aus den Düsenstöcken 2 und 3 mit flüssigem, Säure oder Lauge und Oxidationsmittel enthaltendem Ätzmittel besprüht. Im unteren Bereich der Ätzkammer 1 befindet sich ein Ätzmittelsumpf 4. Entnahmeleitung, Pumpen, Zufuhrleitungen zu den Düsenstöcken und Vorratsbehälter sind, wie bereits oben erwähnt, in der Zeichnung nicht dargestellt.

Eine zentrale Steuerelektronik 20 ist über elektrische Leitungen 12, 11, 10 mit der optischen Reflexions-Meßeinrichtung 7 o, u, der Dickenmeßeinrichtung 8 o, u und dem Detektor 9 verbunden und empfängt von diesen elektrische Signale, die den jeweiligen Meßwerten entsprechen. Die zentrale Steuerelektronik 20 kann auch über eine Leitung mit einem als Eingabeeinheit dienenden Tastenfeld (nicht dargestellt) verbunden sein. Die zentrale Steuerelektronik ist über elektrische Leitungen 13, 14 mit einer Meßelektronik 15 verbunden. Die Meßelektronik 15 ihrerseits ist über elektrische Leitungen 17, 16 mit Durchflußmengenmessern M1, M2, M3, die jeder einzelnen Düse D1, D2, D3 des oberen Düsenstocks 2 und des unteren Düsenstocks 3 zugeordnet sind, verbunden. Als Durchflußmengenmesser kommen beispielsweise Auftriebskörper-Messer, oder mit dem fließenden Ätzmittel laufende Turbinen, oder Sensoren, welche eine Messung mittels Ultraschall gestatten, oder Staudruckmesser und dergl. in Frage. Jedem Durchflußmengenmesser ist ein elektrischer Meßwertgeber zugeordnet, der jeweils mit einer eigenen Meßelektronik verbunden ist. Alternativ ist es auch möglich, alle Meßwertgeber über einen von einem Taktgeber gesteuerten Multiplexer sequentiell und zyklisch mit einer einzigen Meßelektronik zu verbinden und das Ausgangssignal der Meßelektronik über einen von dem Taktgeber sequentiell und zyklisch gesteuerten Demultiplexer einer Sichtanzeige zuzuführen. Es kann auch für jede Düse eine Vergleichswertschaltung vorgesehen sein, die untere zulässige Grenzwerte für die durch jede Düse strömende Ätzmittelmenge festlegt. Bei Unterschreiten des Grenzwerts wird über einen Komparator eine Hilfsfunktion erzeugt, die der Sichtanzeige zugeführt wird. Weitere Einzelheiten über Durchflußmengenmesser, deren Bauweise und Funktion können der deutschen Offenlegungsschrift DE-A-33 45 125 entnommen werden.

Mit Hilfe der Durchflußmengenmesser kann die Menge des jeder Düse zugeführten Ätzmittels bzw. der entsprechende Sprühdruck individuell gemessen werden, und die Meßelektronik 15 gibt über die Leitungen 13, 14 die elektrischen Signale, die den Meßwerten für die den Düsen zugeführten Ätzmittelmengen bzw. den Drucken entsprechen, an die zentrale Steuerelektronik 20. Über elektrische Leitungen 18, 19 ist die Steuerelektronik 20 mit den Regelventilen V1, V2, V3, die mit den Durchflußmengenmessern in jeder Düsenzufuhrleitung in Reihe gelegt sind, verbunden. Durch die von der Steuerelektronik 20 übermittelten Ausgangssignale werden die Regelventile betätigt und die Menge des jeder Düse zugeführten Ätzmittels bzw. der Sprühdruck individuell geregelt.

Die Funktionsweise der beschriebenen Ätzanlage ist wie folgt:
Es ist das Ziel, den Sprühdruck des Ätzmittels an den einzelnen Düsenstöcken, bzw. den einzelnen Düsen für jeden einzelnen Ätzvorgang in einen bestimmten Bezug zur Menge des abzuätzenden Metalls am Ätzgut 5 zu setzen.

Hierzu empfängt die zentrale Steuerelektronik 20 über die Leitungen 12, 11 erste Signale, d. h. Daten über die Fläche und Dicke der abzutragenden Metallschicht von den Einrichtungen 7 o, u und 8 o, u. Aus diesen Daten ermittelt die Steuerelektronik die Menge des abzutragenden Metalls an dem Ätzgut 5, das gerade die Einrichtungen 7 o, u und 8 o, u durchläuft und in der Ätzanlage geätzt werden soll. Nach einem eingespeicherten Programm beispielsweise ordnet die Steuerelektronik 20 der ermittelten Menge des abzutragenden Metalls die entsprechenden Sprühdrucke (Sollwerte) an den einzelnen Düsenstöcken 2, 3 bzw. Düsen oberhalb und unterhalb des Ätzguts zu, sofern diese nicht auf konstante Werte für den Sprühdruck eingestellt werden sollen.

Wenn der Detektor 9 der zentralen Steuerelektronik 20 über die Leitung 10 ein zweites Signal zuführt, das das Einlaufen des Ätzguts 5 in die Ätzkammer 1 anzeigt, erzeugt die Steuerelektronik 20 vierte Signale, welche für die Sollwerte der Sprühdrucke an den Düsen repräsentativ sind.

Der Steuerelektronik 20 werden auch von der Meßelektronik 15 erstellte dritte Signale, welche für die Istwerte der Durchflußmengen bzw. Drucke an den einzelnen Düsen repräsentativ sind, über Leitungen 14, 13 zugeführt. Die Steuerelektronik vergleicht diese dritten Signale mit den vierten, für die Sollwerte der Drucke repräsentativen Signalen. Die resultierenden fünften Signale werden über elektrische Leitungen 19, 18 den Regelventilen V1, V2, V3 der einzelnen Düsen D1, D2, D3 in den Düsenstöcken 2, 3 oberhalb und unterhalb des Ätzguts zu deren Betätigung bzw. zur Einstellung des errechneten und korrigierten Sprühdrucks zugeführt.

Zur Veranschaulichung der Prozeßsteuerung wird auf Fig. 3 verwiesen. Die Steuerelektronik 20 errechnet aus den Signalen 1 (Reflexion 7 o, u und Dicke 8 o, u) und Signal 2 (Einlauf Ätzgut) den Sollwert des Sprühdrucks an den Düsen. Der Sollwert ist in Fig. 3 mit Führungsgröße W bezeichnet und entspricht Signal 4. Aus der Meßelektronik 15 werden dem Regelkreis Signale 3 zugeführt, welche dem Istwert der Durchflußmengen bzw. der Sprühdrucke an den einzelnen Düsen entsprechen. Der Istwert umfaßt in Fig. 3 die Störgröße Z und die Regelgröße X. Ein Vergleich dieser Größen mit der Führungsgröße W (Signale 3 und 4) ergibt die Stellgröße Y des Regelkreises. Mit der Stellgröße Y wird der Sprühdruck an den Düsen während des Ätzprozesses geregelt.

Die Vorrichtung der Erfindung ist besonders zum Ätzen von Leiterplatten geeignet, bei der die Leiterzugmuster auf Plattenoberseite und Unterseite senkrecht zueinander verlaufen. In einem ersten Ausführungsbeispiel sind in der Ätzkammer auf der Unterseite des Ätzguts 7 Düsenstöcke in paralleler Anordnung zur Richtung der Leiterzüge auf der Leiterplatte vorgesehen. Da die Leiterplatte in diesem Ausführungsbeispiel in Richtung der Leiterzüge auf der Unterseite der Platte in die Ätzmaschine eingeführt wird, wird der Sprühdruck an den einzelnen Düsenstöcken bzw. Düsen auf der Unterseite auf bestimmte, von der zu ätzenden Leiterzugdichte abhängige stationäre Werte eingestellt, wobei die optimalen Werte vorher experimentell ermittelt wurden. Auf der Oberseite des Ätzguts sind in diesem Ausführungsbeispiel 5 Düsenstöcke in paralleler Anordnung zur Richtung der Leiterzüge vorgesehen. Da das Leiterzugmuster auf der Oberseite der Platte aber senkrecht zu dem auf der Unterseite und deshalb auch senkrecht zur Durchlaufrichtung durch die Ätzmaschine verläuft, ist während des Durchlaufs der Platte eine kontinuierliche Regelung des Sprühdrucks an den Düsenstöcken bzw. den einzelnen Düsen in Abhängigkeit von der Leiterzugdichte erforderlich. Einzelheiten der Regelung sind zuvor beschrieben.

Wie zuvor erwähnt, ist es besonders vorteilhaft, der ersten Ätzkammer eine zweite nachzuschalten. In der zweiten Ätzkammer verlaufen die Düsenstöcke auf der Oberseite senkrecht zu denen in der ersten Ätzkammer. Entsprechendes gilt für den Verlauf der Düsenstöcke in beiden Ätzkammern auf der Unterseite. In der zweiten Ätzkammer wird der Sprühdruck auf der Oberseite an den einzelnen Düsenstöcken oder Düsen auf konstante Werte eingestellt, während er an den Düsenstöcken oder Düsen auf der Unterseite durch die zuvor beschriebene Regelung kontinuierlich geregelt wird.

Wenn aus Platzgründen nur eine Ätzkammer vorgesehen werden kann, dann kann dieselbe auf Oberseite und Unterseite jeweils mit zwei senkrecht zueinander angeordneten Düsenstocksystemen versehen werden. Beim ersten Durchlauf durch die Ätzkammer werden auf Ober- und Unterseite die beiden ersten, senkrecht zueinander verlaufenden Düsenstocksysteme verwendet und beim zweiten Durchlauf durch dieselbe Kammer die beiden zweiten, senkrecht zueinander und senkrecht zu den ersten Düsenstocksystemen verlaufenden Düsenstocksysteme. Es ist auch möglich, eine Ätzkammer mit nur einem System an Düsenstöcken auszustatten, die senkrecht zueinander verlaufen und Einrichtungen an den Düsenstöcken vorzusehen, mit denen die Sprührichtung beim zweiten Durchgang des Ätzguts durch die Ätzkammer umgestellt werden kann.

In einem zweiten, in der Zeichnung nicht dargestellten Ausführungsbeispiel werden als Ätzgut Platten, auf denen beispielsweise Kupfer in einzelnen Bereichen mit unterschiedlicher Dicke abgeschieden wurde, geätzt. Unterschiedliche Schichtdicken können bei der stromlosen oder elektrolytischen Abscheidung von Kupfer erhalten werden, wenn apparative Mängel vorliegen oder Störungen während des Abscheidungsprozesses auftreten. Auch in diesem Ausführungsbeispiel ist es vorteilhaft, eine Ätzvorrichtung mit zwei hintereinander geschalteten Ätzkammern der zuvor beschriebenen Bauart zu verwenden. Beim Durchgang des Ätzguts durch die erste Kammer kann beispielsweise der Sprühdruck des Ätzmittels an den Düsenstöcken oder Düsen oben kontinuierlich in Abhängigkeit von der jeweiligen Höhe der abzuätzenden Kupferschicht kontinuierlich geregelt werden und auf der Unterseite an den senkrecht zu den Düsenstöcken auf der Oberseite verlaufenden auf während des Durchlaufs konstante Werte eingestellt werden. In der zweiten Ätzkammer ist der Verlauf der Düsenstöcke auf Ober- und Unterseite senkrecht zu dem der Düsenstöcke in der ersten Kammer. Die Sprühdrucke an den Düsenstöcken oder Düsen werden entsprechend dem anderen Verlauf ebenfalls anders geregelt, d. h. oben werden konstante Werte eingestellt und unten wird kontinuierlich in Abhängigkeit von der Dicke der abzutragenden Schicht geregelt.

Es versteht sich, daß die Prozeßsteuerung nicht an das starre, zuvor beschriebene Schema gebunden ist, sondern daß die Regelung in der oder einzelnen Ätzkammern und an den einzelnen Düsenstöcken bzw. Düsen in vielfältiger Weise an das zu bearbeitende Ätzgut angepaßt werden kann.

## Patentansprüche

1. Verfahren zum Ätzen von zumindest teilweise aus Metall bestehendem Ätzgut, vorzugsweise von gedruckten Leiterplatten, mit einer Ätzmaschine, welche Düsenstöcke mit einer vielzahl von Düsen umfaßt, die oberhalb und unterhalb des Ätzguts senkrecht zueinander angeordnet sind und denen Ätzmittel über Flüssigkeits-Sammelleitungen und über von diesen abzweigende individuelle Flüssigkeits-Zufuhrleitungen zugeführt wird,
dadurch gekennzeichnet,
daß die Sprühdrucke in jedem Düsenstock oder in den einzelnen Düsen, bei Anordnung der Leiterzüge parallel zu den Düsenstöcken und zur Durchlaufrichtung durch die Ätzmaschine, auf der Leiterzugdichte entsprechende, aber während des Durchlaufs der Leiterplatte konstante Werte eingestellt werden; bei Anordnung der Leiterzüge parallel zu den Düsenstöcken aber senkrecht zur Durchlaufrichtung durch die Ätzmaschine, auf der Leiterzugdichte entsprechende Anfangswerte eingestellt werden, die beim Durchlauf der Leiterplatte an jedem Düsenstock, bzw. an jeder Düse in Abhängigkeit von der Leiterzugdichte angehoben oder abgesenkt werden; und Meß- und Regeleinrichtungen vorgesehen sind, mit denen die den Düsenstöcken oder den einzelnen Düsen zugeführten Flüssigkeitsmengen bzw. die Sprühdrucke an denselben individuell regelbar sind.

2. Verfahren nach Anspruch 1,
dadurch gekennzeichnet, daß
1. die freiliegenden Oberflächen (7 o, 7 u) und die Dicken (8 o, 8 u) der Metallschichten mit ensprechenden Einrichtungen gemessen und den Mengen des am Ätzgut beidseitig abzutragenden Metalls entsprechende erste Signale erstellt werden;
2. ein Detektor (9) bei Einlauf der Leiterplatte (5) in die Ätzmaschine (1) ein zweites Signal erstellt;
3. in den Flüssigkeits-Zufuhrleitungen zu den einzelnen Düsen (D1, D2, D3) Durchflußmengenmesser (M1, M2, M3) mit elektrischen Meßwertgebern vorgesehen sind, eine Meßelektronik (15) aus den Signalen der Meßwertgeber für die Istwerte der Durchflußmengen an den einzelnen Düsen repräsentative, dritte elektrische Signale erstellt, die der Steuerelektronik (20) zugeführt werden; und daß
4. die Steuerelektronik (20) aus den ersten Signalen die Sollwerte des Sprühdrucks an den einzelnen Düsen der Düsenstöcke oben und unten (2, 3) errechnet, bei Eintreffen des zweiten Signals von Detektor (9) den Sollwerten entsprechende vierte Signale erstellt, diese mit den dritten, den Istwerten entsprechenden Signalen aus der Meßelektronik (15) vergleicht und als fünfte Signale den Regelventilen (V1, V2, V3) der einzelnen Düsen (D1, D2, D3) in den Düsenstöcken oben und unten (2, 3) zur Regelung des Sprühdrucks zuführt (Fig. 2).

3. Verfahren nach den Ansprüchen 1 und 2,
dadurch gekennzeichnet,
daß eine Ätzmaschine (1) verwendet wird, die zwei Ätzkammern umfasst und daß die Düsenstöcke in beiden Kammern oberhalb und unterhalb des Ätzguts senkrecht zueinander und diejenigen in der zweiten Kammer wiederum senkrecht zu denen in der ersten Kammer angeordnet sind.

4. Verfahren nach Anspruch 3,
dadurch gekennzeichnet,
daß in der ersten Ätzkammer der Sprühdruck der Düsenstöcke oder der Düsen an jedem Düsenstock auf der Unterseite des Ätzguts bei einer Anordnung der Düsenstöcke in Richtung der Leiterzüge und in Durchlaufrichtung der Leiterplatte auf während des Durchlaufs konstante Werte eingestellt wird, und der Sprühdruck der Düsenstöcke oder der Düsen an jedem Düsenstock auf der Oberseite des Ätzguts bei einer Anordnung der Düsenstöcke in Richtung der Leiterzüge aber senkrecht zur Durchlaufrichtung der Leiterplatte während des Durchlaufs kontinuierlich in Abhängigkeit von der Leiterzugdichte geregelt wird.

5. Verfahren nach den Ansprüchen 1 und 2,
dadurch gekennzeichnet,
daß in einer Ätzkammer auf Ober- und Unterseite des Ätzguts zwei senkrecht zueinander angeordnete Düsenstocksysteme vorgesehen sind, oder daß nur ein Düsenstocksystem vorgesehen ist mit Einrichtungen an den Düsenstöcken, mit denen die Sprührichtung an den Düsen umgestellt werden kann.

## Claims

1. Method of etching an etch material consisting at least partly of metal, preferably of printed circuit boards, with an etcher comprising jet assemblies with a plurality of jets which are arranged perpendicularly to each other above and below the etch material and which receive etchants through fluid collector lines and individual fluid supply lines branching thereoff,
characterized in that
the spray pressures in each jet assembly or in the individual jets
- with the conductors being arranged parallel to the jet assemblies and the direction of passage through the etcher -
are set to values corresponding to the conductor density but which are constant during the circuit board's passage through the etcher; and
- with the conductors being arranged parallel to the jet assemblies but perpendicularly to the direction of passage through the etcher -
are set to initial values corresponding to the conductor density, which, as the circuit board passes each jet assembly or each jet, may be increased or reduced, depending upon the conductor density;
measuring and regulating devices are provided by which the fluid quantities or spray pressures applied to the jet assemblies or the individual jets are individually controlled.

2. Method as claimed in claim 1,
characterized in that
1. the bared surfaces (7 o, 7 u) and the thicknesses (8 o, 8 u) of the metal layers are measured by suitable means and first signals are emitted corresponding to the quantities of metal to be removed from both sides of the etch material;
2. a detector (9), as the circuit board (5) enters the etcher (1), generates a second signal;
3. flowmeters (M1, M2, M3) with electrical transducers are provided in the fluid supply lines to the individual jets (D1, D2, D3), a measuring electronics (15) generates from the signals of the tranducers third electrical signals representative of the actual values of the flows at the individual jets, which are fed to the control electronics (20); and that
4. the control electronics (20) computes the desired values for the spray pressure at the individual jets of the jet assemblies at the top and the bottom (2, 3) from the first signals, generates fourth signals, corresponding to the desired values, in response to the second signal from detector (9), compares these fourth signals with the third signals, corresponding to the actual values, from the measuring electronics (15), feeding them as fifth signals to the regulating valves (V1, V2, V3) of the individual jets (D1, D2, D3) in the jet assemblies at the top and the bottom (2, 3) for controlling the spray pressure (Fig. 2).

3. Method as claimed in claims 1 and 2,
characterized in that an etcher (1) is used which comprises two etch chambers, and that the jet assemblies in the two chambers above and below the etch material are arranged perpendicularly to each other and those in the second chamber are arranged perpendicularly to those in the first chamber.

4. Method as claimed in claim 3,
characterized in that in the first etch chamber, the spray pressure of the jet assemblies or the jets in each jet assembly on the bottom side of the etch material for jet assemblies arranged in the direction of the conductors and the circuit board's direction of passage is set to constant values during the passage, and the spray pressure of the jet assemblies or the jets at each jet assembly on the top side of the etch material for jet assemblies arranged in the direction of the conductors but perpendicularly to the circuit board's direction of passage is continuously controlled during the passage as a function of the conductor density.

5. Method as claimed in claims 1 and 2,
characterized in that in an etch chamber on the top and the bottom side of the etch material two perpendicularly arranged jet assembly systems are provided or that only one jet assembly system is provided with devices at the jet assemblies by which the spraying direction at the jets can be changed.

## Revendications

1. Procédé pour décaper une pièce au moins partiellement composée d'un métal, de préférence des cartes imprimées, à l'aide d'une machine à décaper englobant des batteries de buses comportant chacune un grand nombre de buses, lesquelles sont disposées au-dessus et au-dessous de la pièce, perpendiculairement les unes aux autres, et qui reçoivent un produit décapant par des collecteurs de liquide et des conduites individuelles d'amenée de liquide dérivant de ces collecteurs, caractérisé en ce que les pressions de pulvérisation, dans chaque batterie de buses ou dans les buses individuelles, sont, quand les impressions conductrices sont disposées parallèlement aux batteries de buse et au sens de passage à travers la machine à décaper, ajustées à des valeurs correspondant à la densité des impressions conductrices mais constantes pendant le passage de la carte imprimée ; quand les impressions conductrices sont parallèles aux batte-ries de buses mais perpendiculaires au sens de pas-sage à travers la machine à décaper, les pressions sont ajustées à des valeurs initiales correspondant à la densité des impressions conductrices, valeurs ini-tiales qui, lors du passage de la carte imprimée devant chaque batterie de buses ou devant chaque buse, sont augmentées ou diminuées en fonction de la densité des impressions conductrices ; et que sont prévus des dispositifs de mesure et de régulation à l'aide desquels on peut régler d'une manière indivi-duelle les quantités de liquide amenées aux batteries de buses ou aux buses individuelles, ou encore les pressions de pulvérisation qui leur sont appliquées.

2. Procédé selon la revendication 1, caractérisé en ce que :
1. l'aire des surfaces dégagées (7 o, 7 u) et les épaisseurs (8 o, 8 u) des couches métalliques sont mesurées à l'aide de dispositifs appropriés, avec production de premiers signaux, correspondant aux quantités du métal à enlever sur les deux côtés de la pièce ;
2. lors de l'entrée de la carte imprimée (5) dans la machine à décaper (1), un détecteur (9) produit un deuxième signal ;
3. on prévoit dans les conduites d'amenée de liquide allant vers les différentes buses (D1, D2, D3) des débitmètres (M1, M2, M3) comportant des transducteurs électriques de mesure ; une électronique de mesure (15) produit, à partir des signaux des transducteurs de mesure correspondant aux valeurs effectives des débits au niveau des différentes buses, des troisièmes signaux électriques représentatifs, qui sont envoyés à l'électronique de commande (20) ; et que
4. l'électronique de commande (20) calcule, à partir des premiers signaux, les valeurs de consigne de la pression de pulvérisation au niveau des buses individuelles des batteries de buses, en position supérieure et en position inférieure (2, 3), puis, lors de l'arrivée du deuxième signal provenant du détecteur (9), produit des quatrièmes signaux correspondant aux valeurs de consigne, les compare aux troisièmes signaux, correspondant aux valeurs effectives, provenant de l'électronique de mesure (15) et les envoie, sous forme de cinquièmes signaux, aux vannes de régulation (V1, V2, V3) des buses individuelles (D1, D2, D3) se trouvant dans les batteries de buses, en haut et en bas (2, 3), pour assurer une régulation de la pression de pulvérisation (Figure 2).

3. Procédé selon les revendications 1 et 2, caractérisé en ce qu'on utilise une machine à décaper (1) compor-tant deux compartiments de décapage, et que les bat-teries de buses sont disposées dans les deux compartiments, au-dessus et au-dessous de la pièce à décaper, perpendiculairement les unes aux autres, celles se trouvant dans le deuxième compartiment étant pour leur part perpendiculaires à celles se trouvant dans le premier compartiment.

4. Procédé selon la revendication 3, caractérisé en ce que, dans le premier compartiment de décapage, on ajuste à des valeurs constantes pendant le passage la pression de pulvérisation des batteries de buses ou des buses de chaque batterie de buses, sur le côté inférieur de la pièce à décaper, quand les batteries de buses sont disposées dans la direction des impres-sions conductrices et dans le sens de passage de la carte imprimée, la pression de pulvérisation des bat-teries de buses ou des buses de chaque batterie de buses se trouvant sur le côté supérieur de la pièce à décaper étant, quand les batteries de buses sont dis-posées dans la direction des impressions conductrices mais perpendiculairement au sens de déplacement de la carte imprimée,régulée en continu pendant le passage, en fonction de la densité des impressions conductri-ces.

5. Procédé selon les revendications 1 et 2, caractérisé en ce qu'on prévoit dans un compartiment de décapage, sur le côté supérieur et le côté inférieur de la pièce à décaper, deux systèmes de batteries de buses, disposés perpendiculairement l'un à l'autre, ou en ce qu'on ne prévoit qu'un seul système de batteries de buses, avec des dispositifs, rapportés aux batteries de buses, a l'aide desquels on peut modifier le sens de pulvérisation des buses.
